# EUROPÄISCHE PATENTSCHRIFT

(11) **EP 1 014 139 B1**
(45) Veröffentlichungstag und Bekanntmachung des Hinweises auf die Patenterteilung: **23.03.2005**
(21) Anmeldenummer: 99124503.6
(22) Anmeldetag: 09.12.1999
(51) Int. Cl.: G02B 7/02, G02B 7/192, G02B 3/14, G02B 27/00, G03F 7/20

(54) **Optisches System, insbesondere Projektionsbelichtungsanlage der Mikrolithographie, mit einer optischen Halterung mit Aktuatoren**
Optical system, especially for a projection exposure system for microlithography, having a optical mount comprising actuators
Système optique, notamment pour un systeme d'exposition pour la microlithographie, comprenant une monture optique comportant des actuateurs

(30) Priorität: 23.12.1998 DE 19859634
(43) Veröffentlichungstag der Anmeldung: 28.06.2000
(73) Patentinhaber: Carl Zeiss SMT AG, 73447 Oberkochen (DE)
(72) Erfinder: Merz, Erich, Dipl.-Ing. (FH), 73457 Essingen (DE); Becker, Jochen, Dipl.-Ing. (BA), 73446 Oberkochen (DE)
(74) Vertreter: Lorenz, Werner, Dr.-Ing.

(56) Entgegenhaltungen:
- EP-A- 0 480 616
- EP-A- 0 964 281
- WO-A-99/66361
- WO-A-99/67683
- DE-A- 19 637 563
- US-A- 4 540 251
- US-A- 5 383 168

## Beschreibung

Die Erfindung betrifft ein optisches System, insbesondere Projektions-Belichtungsanlage der Mikrolithographie, insbesondere mit schlitzförmigem Bildfeld oder nicht-rotationssymmetrischer Beleuchtung, das ein optisches Element, insbesondere eine Linse oder einen Spiegel, das in einem Innenring angeordnet ist, und Aktuatoren aufweist, die an dem optischen Element und/oder dem Innenring angreifen.

In der EP 0 678 768 A2 ist ein optisches System der eingangs erwähnten Art beschrieben, wobei Step- und Scan-Prozesse eingesetzt werden, und wobei von einer Maske nur ein schmaler, schlitzförmiger Streifen auf einen Waver übertragen wird. Um das gesamte Feld zu belichten, werden dabei ein Reticle und der Waver seitlich verschoben.

Nachteilig bei dem optischen System nach diesem Stand der Technik ist jedoch, dass durch die Schlitzgeometrie vor allem auf wavernahen Linsen ein rotationsunsymmetrischer Beleuchtungsabdruck entsteht. Dies bedeutet, dass die durch die zwangsläufige Linsenerwärmung entstehende Temperaturverteilung auf der Linse ebenfalls rotationsunsymmetrisch ist und deshalb über den linearen Zusammenhang Brechzahl-Temperatur und thermische Ausdehnung Bildfehler wie z.B. Astigmatismus, auf der optischen Achse entstehen.

Ein weiteres Problem bei einem derartigen optischen System ist der sogenannte Compaction-Effekt, nämlich eine durch die Bestrahlung bedingte Alterung, was ebenfalls zu Bildfehlern führt.

In der EP 0 678 768 A2 wird nun vorgeschlagen eine Linse als "Stellglied" zu verwenden, um den durch eine ungleichmäßige Erwärmung der Linse erzeugten Bildfehler zu korrigieren. Hierzu läßt man in radialer Richtung wirkende Kräfte auf die Linse einwirken. Nachteilig dabei ist jedoch, dass auf diese Weise nur Druckkräfte erzeugt werden, die eine asymmetrische Dickenänderung erzeugen.

In der EP 0 660 169 A1 ist eine Projektion-Belichtungsanlage der Mikrolithographie beschrieben, bei der Objektive mit Korrekturelementen versehen sind. Unter anderem ist hierzu ein Linsenpaar ausgewählt, dass um die optische Achse drehbar ist. Dabei wird die Brechkraft durch die Form der Linse durch Überlagerung einer zylindrischen Meniskus-Form über eine sphärische Linse geändert.

In der älteren WO 99/67683 ist ein optisches System beschrieben, wobei durch Aktuatoren, die an einen Innenring eines optischen Elements angreifen, Kräfte erzeugt werden, die parallel zur optischen Achse wirken.

Die US 5,383,168 bezieht sich auf Lichtstrahlscanner mit einem optischen Kopf, wobei Verbesserungen in der Positionierung der optischen Komponenten in dem optischen Kopf vorgenommen werden sollen, um eine höhere optische Leistung zu erhalten. Dies betrifft insbesondere eine exaktere Kompensation von wärmeinduzierten Fokusverschiebungen. Dabei werden über Aktuatoren, welche in Richtung der optischen Achse angreifen, entsprechende Verschiebungen und Verkippungen erreicht.

Der vorliegenden Erfindung liegt die Aufgabe zugrunde, ein optisches System der eingangs erwähnten Art zu schaffen, bei dem Bildfehler, wie sie z.B. durch eine ungleichmäßige Temperaturverteilung und/oder den Kompaction-Effekt entstehen, durch einen gezielten Astigmatismus korrigiert bzw. zumindest deutlich reduziert werden können.

Erfindungsgemäß wird diese Aufgabe durch die in Anspruch 1 genannten Merkmale gelöst.

Im Unterschied zum Stand der Technik werden nicht lediglich Druckkräfte erzeugt, die nur eine asymmetrische Dickenänderung ergeben, sondern durch gezielt erzeugte Zug- und/oder Druckkräfte eine Deformation des optischen Elementes z.B. einer Linse, erzielt, die so gewählt wird, dass auftretende Bildfehler weitestgehend kompensiert werden.

Erfindungsgemäß ist dabei für die Kraft-Weg-Übersetzung eine Winkelhebelübersetzung vorgesehen, wobei an einem Ende des Winkelhebels wenigstens ein Aktuator und an einem anderen zu dem Innenring gerichteten Ende des Winkelhebels dieser an dem Innenring derart angreift, dass eine Kraft parallel zur optischen Achse an dem Innenring erzeugt wird.

Durch eine geschickte Anordnung bzw. Verteilung der Zug- und Druckkräfte, die entsprechend über den Umfang verteilt angeordnet sind, läßt sich z.B. für den Innenring, der die Linse trägt, und damit auch für die Linse z.B. eine Zweiwelligkeit erzeugen. Dies ist insbesondere dann der Fall, wenn sich die Zug- und Druckkräfte jeweils um 180° gegenüber liegen, wobei sich jeweils nach 90° Zug- und Druckkräfte abwechseln und der Innenring jeweils durch dazwischen liegende Anbindungen fest mit der Fassung verbunden ist.

Mit dem auf diese Weise erzeugten Astigmatismus lassen sich Bildfehler weitgehend ausgleichen. Praktisch nimmt das optische Element, wie z.B. eine Linse, bei der auf diese Weise erzeugten Verformung eine sattelartige Ausbildung ein.

Im Bedarfsfalle ist es auch möglich "Überkompensierung" vorzunehmen, um auf diese Weise eine zusätzliche Kompensation von Fertigungsfehlern oder Bildfehlern anderer optischer Elemente des Systems mit zu korrigieren. Auf diese Weise läßt sich insgesamt gesehen eine Kompensierung eines ganzen Objektives oder einer Belichtungsanlage mit einfachen Mitteln erreichen.

Zur Erzeugung der Zug- und Druckkräfte sind verschiedene Krafterzeuger möglich, wobei man im allgemeinen zur Erhöhung der Genauigkeit bzw. für eine entsprechende Feineinstellung eine Hebelübersetzung vornehmen wird. Als einfache Zug- und Druckkrafterzeuger lassen sich Aktuatoren in Form von Piezoeinheiten oder von Hydraulikeinheiten oder in vorteilhafter Weise mechanische Zug- und Druckeinheiten einsetzen, welche man in einer einfachen Bauweise in der Fassung anordnen kann. Durch diese Maßnahme läßt sich die Fassung gleichzeitig zur Abdichtung für die Hydraulik oder zur Aufnahme der Zug- und Druckeinheiten verwenden.

Vorteilhafte Weiterbildungen und Ausgestaltungen ergeben sich aus den übrigen Unteransprüchen und aus dem nachfolgend anhand der Zeichnung prinzipmäßig beschriebenen Ausführungsbeispiel.

Es zeigt:
- Figur 1: eine perspektivische Darstellung eines optischen Systems mit einem Innenring, der mit einer Fassung verbunden ist,
- Figur 2: eine Darstellung des Funktionsprinzips zur Erzeugung von Zug- und Druckkräften an dem deformierbaren Innenring, auf welchem das optische Element gelagert ist,
- Figur 3: eine Prinzipdarstellung einer mechanischen Zugeinheit zur Erzeugung einer Zugkraft, und
- Figur 4: eine Prinzipdarstellung einer mechanischen Druckeinheit zur Erzeugung einer Druckkraft.

Da eine Projektions-Belichtungsanlage in der Mikrolithographie allgemein bekannt ist, wird nachfolgend nur ein optisches Element 1, das in eine derartige Anlage eingebaut ist und das hierzu in bzw. an einem Innenring 2 gelagert ist, welcher mit einer Fassung 7 verbunden ist, prinzipmäßig beschrieben.

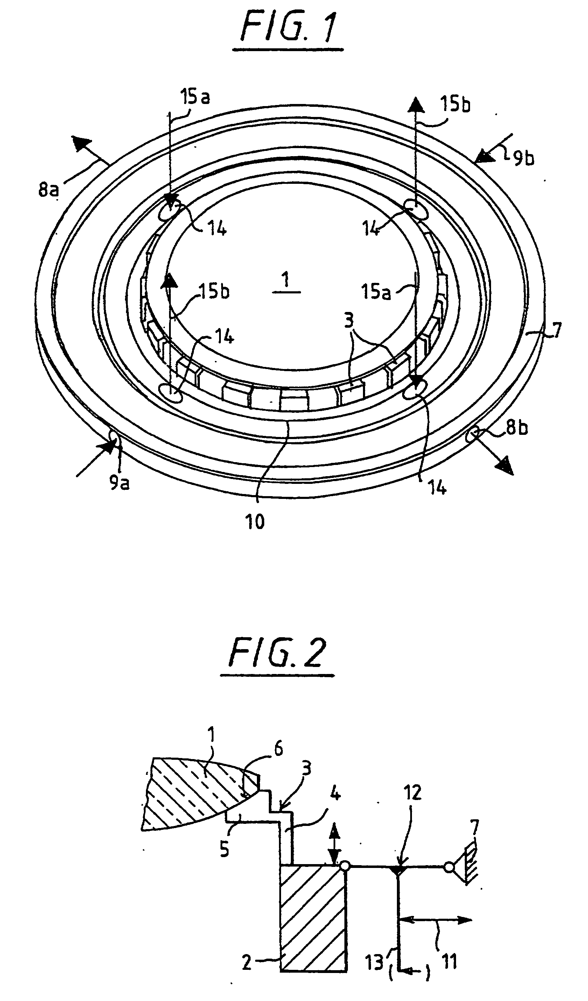

Das optische Element, z.B. eine Linse 1 (in der Figur 2 nur teilweise und in der Figur 1 vollständig dargestellt) ist auf einer Vielzahl von gleichmäßig über den Umfang eines Innenringes 2 verteilt angeordneten winkelförmig ausgebildeten Auflagefüßchen 3 gelagert. Jeweils mit dem Innenring 2 verbundene Teile 4 der Auflagefüßchen 3 liegen parallel zur optischen Achse. Rechtwinklig dazu verlaufen nach innen gerichtete Zwischenteile 5 der Auflagefüßchen 3, die Auflageflächen 6 für die Linse 1 aufweisen. Durch diese Ausgestaltung der Auflagefüßchen 3 wird zum Einen eine präzise Lagerung und zum Anderen auch eine Elastizität zur Einbringung von Deformationen auf die Linse 1 als optisches Element geschaffen.

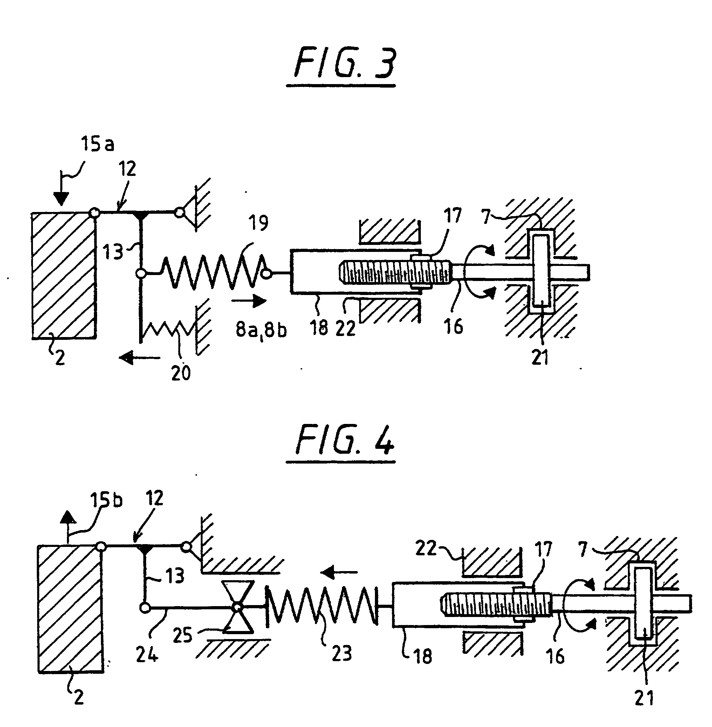

In einer den Innenring 2 umgebenden Fassung 7 sind sich um 180° gegenüberliegend zwei Aktuatoren in Form von Zugeinheiten 8a und 8b angeordnet, die in radialer Richtung bzw. senkrecht zur optischen Achse wirkende Zugkräfte erzeugen. Um 90° versetzt dazu liegen ebenfalls um 180° sich gegenüberliegend zwei weitere Druckeinheiten 9a, 9b, die Druckkräfte ebenfalls in radialer Richtung erzeugen. Die Zug- und Druckeinheiten sind in der Figur 1 nur angedeutet und werden in den Figuren 3 und 4 nachfolgend prinzipmäßig bezüglich ihres Funktionsprinzips beschrieben.

Jeweils mittig zwischen zwei um 90° versetzt zueinander liegende Zug- und Druckeinheiten, d.h. jeweils 45° dazwischen befindet sich eine Anbindung 10, über die der Innenring 2 fest mit der Fassung 7 verbunden ist. Die Verbindung kann auf beliebige Weise erfolgen. In der Figur 1 sind diese ebenfalls nur angedeutet wobei aufgrund der perspektivischen Darstellung nur drei der vier Anbindungen 10 erkennbar sind.

Die von den Zug- und Druckeinheiten 8a, 8b und 9a, 9b aufgebrachten radialen Zug- Druckkräfte entsprechend Pfeilrichtung 11 in der Figur 2 werden auf folgende Weise in Kräfte umgewandelt, die parallel zur Z-Achse wirken und Astigmatismus erzeugen.

Wie aus der Figur 2 ersichtlich ist, ist hierzu eine Hebelübersetzung mit Winkelhebeln 12 vorgesehen, die sich zwischen dem Innenring 2 und der Fassung 7 befinden. Die Winkelhebel 12 besitzen jeweils im Querschnitt gesehen eine T-Form, wobei sich der "T-Balken" rechtwinklig zur optischen Achse erstreckt. An einem Ende des Hebels bzw. des T-Balkens ist der Winkelhebel 12 nachgiebig bzw. gelenkartig mit der Fassung 7 verbunden und am anderen, dem Innenring 2 zugewandten Ende entsprechend gelenkartig mit dem Innenring 2. Zwischen beiden Enden des T-Balkens erstreckt sich senkrecht dazu und parallel zur Z-Achse ein Hebelarm 13, an dem die Zug- und Druckkräfte 11 der Zug- und Druckeinheiten 8a, 8b und 9a, 9b angreifen.

Entsprechend der Anzahl und Anordnung der Zug- und Druckeinheiten 8a, 8b und 9a, 9b sind vier Winkelhebel 12 in einem Abstand von 90° über den Umfang verteilt vorgesehen. Dies bedeutet, zusammen mit den vier Anbindungen 10, daß der Innenring 2 über insgesamt acht Verbindungsstellen mit der Fassung 7 elastisch verbunden ist. In der Fig. 1 sind Taschen 14 zwischen dem Innenring 2 und der Fassung 7 erkennbar, in denen die Winkelhebel 12 eingesetzt sind.

Je nach Pfeilrichtung 11 des Kraftangriffes ergeben sich bei dem Ausführungsbeispiel über den Umfang verteilt abwechselnd nach unten oder nach oben gerichtete Kräfte auf den Innenring 2 entsprechend der in Figur 1 dargestellten Pfeile 15a (nach unten gerichtet) und 15b (nach oben gerichtet).

Im Prinzip ließen sich ein Astigmatismus auch nur durch Zugoder Druckkräfte, d.h. nur nach oben oder nur nach unten gerichtete Kräfte erzeugen aber durch die gewählte Ausbildung in abwechselnder Form ergibt sich aufgrund der jeweils dazwischen liegenden festen Anbindung 10 eine Zweiwelligkeit bzw. Sattelform der Linse 1 mit dem Vorteil, daß sich kein Versatz der Linse 1 in Z-Richtung ergibt.

Durch die in den Figuren 3 und 4 dargestellten Zug- und Druckkräfte wird gleichzeitig auch eine Übersetzung derart erzeugt, daß eine Übersetzung von einem großen Weg in eine feinfühlige Verstellung der Linse 1 erfolgt. Übersetzungsverhältnisse lassen sich dabei in einfacher Weise auch durch die Auswahl der Hebellängen variieren.

Die in den Figuren 3 und 4 dargestellten Zug- und Druckeinheiten 8a, 8b und 9a, 9b, wobei in der Figur 3 eine Zugeinheit und in der Figur 4 eine Druckeinheit dargestellt sind, weisen einen Spindelantrieb 16 auf, der in der Fassung 7 gelagert ist. Die Spindelmutter 17 des Spindelantriebes 16 ist mit einer Führungshülse 18 verbunden, welche ebenfalls in der Fassung 7 gelagert ist. Eine Zugfeder 19 ist mit ihrem einen Ende mit der Führungshülse 18 verbunden und greift mit ihrem anderen Ende an dem Hebelarm 13 des Winkelhebels 12 an. Zur Erzeugung von nach unten gerichteten Kräften 15a an der Linse 1 wird der Spindelantrieb 16 derart gedreht, daß sich über die Spindelmutter 17 und damit auch für die Führungshülse 18 eine translatorische Bewegung in Pfeilrichtung 8a, 8b ergibt. Bei Verwendung einer entsprechend "weichen" Zugfeder 19 läßt sich eine große Übersetzung ins kleine, d.h. mit mehreren Spindelumdrehungen, eine geringe bzw. feinfühlige Verstellkraft in Pfeilrichtung 15a erzeugen.

Bei Bedarf kann noch eine Vorspannfeder 20 zum Ausgleich der Zugfeder 19 vorgesehen werden. Die Lagerung des Spindelantriebes 16 in der Fassung 7 ist prinzipmäßig durch eine Scheibe 21 und Gleitlager 22 für die Führungshülse 18 dargestellt.

Die in der Figur 4 dargestellte Druckeinheit ist grundsätzlich vom gleichen Aufbau und weist auch die gleichen Teile auf. Anstelle einer Zugfeder 19 ist hier jedoch eine Druckfeder 23 vorgesehen, die bei einer Verdrehung des Spindelantriebes 16 und einer daraus resultierenden translatorischen Bewegung der Spindelmutter 17 mit der Führungshülse 18 eine Bewegung in Pfeilrichtung 9a, 9b erzeugt. Über den Hebelarm 13 des Winkelhebels 12, an dem eine mit der Druckfeder 23 verbundene Druckstange 24 angreift, ergibt sich eine nach oben gerichtete Kraft 15b an der Linse 1. Neben der Lagerung gemäß Figur 3 ist hier aufgrund der Druckfeder 23 und der Druckstange 24 eine zusätzliche Lagerung bzw. Führung 25 an der Druckstange 24 vorzusehen.

Anstelle der in den Figuren 3 und 4 prinzipmäßig beschriebenen mechanischen Zug- und Druckeinheiten sind selbstverständlich auch Hydraulikeinheiten zur Erzeugung der Kräfte 15a und 15b möglich. Ebenso ist ein Piezoantrieb denkbar.

## Patentansprüche

1. Optisches System mit einer optischen Achse, insbesondere Projektions-Belichtungsanlage der Mikrolithographie, insbesondere mit schlitzförmigem Bildfeld oder nicht-rotationssymmetrischer Beleuchtung, das ein optisches Element, insbesondere eine Linse oder einen Spiegel, das in einem Innenring angeordnet ist, und Aktuatoren aufweist, die über Winhelhebel an dem Innenring angreifen, wobei zur Erzeugung von Zug- und/oder Druckkräften an dem deformierbaren Innenring (2) über eine Kraft-Weg-Übersetzung mehrere Aktuatoren (8a, 8b und 9a, 9b) angreifen, wobei für die Kraft-Weg-Übersetzung eine Hebelübersetzung mit einem Winkelhebel (12) vorgesehen ist, und wobei jeweils an einem Ende eines Winkelhebels (12) wenigstens ein Aktuator (8a, 8b und 9a, 9b) in eine Richtung senkrecht zur optischen Achse und an einem anderen, zu dem Innenring (2) gerichteten Ende des Winkelhebels (12) dieser an dem Innenring (2) derart angreift, dass eine Kraft parallel zur optischen Achse an dem Innenring (2) erzeugt wird.

2. Optisches System nach Anspruch 1, **dadurch gekennzeichnet, dass** jeweils sich um 180° gegenüberliegend Zug- oder Druckkräfte an Hebeln (12) angreifen, wobei sich jeweils nach 90° Zug- und Druckkräfte abwechseln und der Innenring (2) jeweils durch dazwischen liegende Anbindungen (10) fest mit der Fassung (7) verbunden ist.

3. Optisches System nach Anspruch 1 oder 2, **dadurch gekennzeichnet, dass** die Winkelhebel (12) im Abstand von 90° zwischen dem Innenring (2) und der Fassung (7) angeordnet sind, wobei die Winkelhebel (12) am Außenumfang nachgiebig mit der Fassung (7) verbunden sind und gelenkartig am Innenumfang an dem Innenring (2) angreifen, und wobei die Aktuatoren (8a, 8b und 9a, 9b) jeweils an einem parallel zur optischen Achse verlaufenden Hebelarm (13) der Winkelhebel (12) angreifen.

4. Optisches System nach einem der Ansprüche 1 bis 3, **dadurch gekennzeichnet, dass** an dem Innenring (2) winkelförmig ausgebildete Auflagefüßchen (3) über den Umfang des Innenrings (2) verteilt angeordnet sind, wobei die mit dem Innenring (2) verbundenen Teile (4) der Füßchen (3) parallel zur optischen Achse gerichtet sind und rechtwinklig dazu nach innen verlaufende Zwischenteile (5) Auflageflächen für das optische Element (6) aufweisen.

5. Optisches System nach einem der Ansprüche 1 bis 4, **dadurch gekennzeichnet, dass** die Aktuatoren (8a, 8b und 9a, 9b) als mechanische Zug- und Druckeinheiten (8a, 8b und 9a, 9b) ausgebildet sind.

6. Optisches System nach Anspruch 5, **dadurch gekennzeichnet, dass** die Zug- und Druckeinheiten (8a, 8b und 9a, 9b) mit einem Spindelantrieb (16) versehen sind, wobei über die Spindelmutter (17) eine Zug- und Druckkraft auf eine Federeinrichtung (19,23) ausübbar ist, die an dem dazugehörigen Hebel (12) angreift.

7. Optisches System nach Anspruch 6, **dadurch gekennzeichnet, dass** durch die Federeinrichtung (19,23) eine Übersetzung von einem großen Verstellweg in eine Feinverstellung am Hebel (12) eingestellt ist.

8. Optisches System nach Anspruch 7, **dadurch gekennzeichnet, dass** die Zug- und Druckeinheiten (8a, 8b und 9a, 9b) in Bohrungen der Fassung (7) angeordnet sind.

## Claims

1. Optical system having an optical axis, in particular a projection exposure system for microlithography, in particular with a slit-shaped image field or non-rotationally symmetric illumination, which has an optical element, in particular a lens or a mirror, which is arranged in an inner ring, and actuators which engage on the inner ring via crank levers, wherein a plurality of actuators (8a, 8b and 9a, 9b) engage on the deformable inner ring (2) via a force-displacement transmission in order to generate tensile and/or compressive forces, a lever transmission with a crank lever (12) being provided as the force-displacement transmission, and wherein at least one actuator (8a, 8b and 9a, 9b) respectively engages at one end of a crank lever (12) in a direction perpendicular to the optical axis and, at its another end next to the inner ring (2), this crank lever (12) engages on the inner ring (2) so that a force parallel to the optical axis is generated on the inner ring (2).

2. Optical system according to Claim 1, **characterised in that** tensile or compressive forces respectively opposing by 180° engage on levers (12), tensile and compressive forces respectively alternate after 90° and the inner ring (2) is respectively joined firmly to the frame (7) by connections (10) lying in between.

3. Optical system according to Claim 1 or 2, **characterised in that** the crank levers (12) are arranged at a spacing of 90° between the inner ring (2) and the frame (7), the crank levers (12) are resiliently joined to the frame (7) at the outer circumference and engage on the inner ring (2) in an articulated fashion at the inner circumference, and the actuators (8a, 8b and 9a, 9b) respectively engage on a lever arm (13), which extends parallel to the optical axis, of the crank levers (12).

4. Optical system according to one of Claims 1 to 3, **characterised in that** support feet (3) designed in an angulated fashion are arranged on the inner ring (2), while being distributed over the circumference of the inner ring (2), those parts (4) of the feet (3) which are joined to the inner ring (2) are oriented parallel to the optical axis and intermediate parts (5) extending inwards at right angles thereto have support surfaces for the optical element (6).

5. Optical system according to one of Claims 1 to 4, **characterised in that** the actuators (8a, 8b and 9a, 9b) are designed as mechanical tension and compression units (8a, 8b and 9a, 9b).

6. Optical system according to Claim 5, **characterised in that** the tension and compression units (8a, 8b and 9a, 9b) are provided with a spindle drive (16), and a tensile and compressive force can be exerted via the spindle nut (17) on a spring device (19, 23), which engages on the associated lever (12).

7. Optical system according to Claim 6, **characterised in that** transmission of a large adjustment travel into a fine adjustment on the lever (12) is established by the spring device (19, 23).

8. Optical system according to Claim 7, **characterised in that** the tension and compression units (8a, 8b and 9a, 9b) are arranged in bores of the frame (7).

## Revendications

1. Système optique avec un axe optique, en particulier une installation d'éclairage de projection pour microlithographie, plus particulièrement avec un champ d'image en forme de fente ou un éclairage non symétrique en rotation, qui comprend un élément optique, plus particulièrement une lentille ou un miroir disposé dans une bague intérieure, et des vérins qui sont en prise avec la bague intérieure par l'intermédiaire de leviers angulaires, dans lequel plusieurs vérins (8a, 8b et 9a, 9b) sont en prise avec la bague intérieure déformable (2) par l'intermédiaire d'une démultiplication force-déplacement, pour exercer des forces de traction et/ou de pression, dans lequel une démultiplication force-déplacement par levier avec un levier angulaire (12) est prévue et, à une extrémité d'un levier angulaire (12), au moins un vérin (8a, 8b et 9a, 9b) est en prise avec la bague intérieure (2), dans une direction perpendiculaire à l'axe optique et au niveau d'une autre extrémité du levier angulaire (12) orientée vers la bague intérieure (2), de telle sorte qu'une force parallèle à l'axe optique soit exercée sur la bague intérieure (2).

2. Système optique selon la revendication 1, **caractérisé en ce que** des forces de traction ou de pression s'exercent de manière opposée à 180° sur les leviers (12), les forces de traction et de pression alternant tous les 90° et la bague intérieure (2) étant reliée au support (7) à l'aide de liaisons (10) situées entre eux.

3. Système optique selon la revendication 1 ou 2, **caractérisé en ce que** les leviers angulaires (12) sont disposés avec un intervalle de 90° entre la bague intérieure (2) et le support (7), les leviers angulaires (12) étant reliés, de manière flexible sur la circonférence externe, au support (7) et de manière articulée sur la circonférence intérieure, à la bague intérieure (2) et les vérins (8a, 8b et 9a, 9b) étant en prise avec un bras de levier (13) parallèle à l'axe optique des leviers angulaires (12).

4. Système optique selon l'une des revendications 1 à 3, **caractérisé en ce que**, sur la bague intérieure (2) se trouvent des pieds d'appuis (3) de forme angulaire répartis sur la circonférence de la bague intérieure (2), les composants (4) des pieds (3) reliés à la bague intérieure (2) étant orientés parallèlement à l'axe optique et des composants intermédiaires (5) perpendiculaires à celui-ci présentant des surfaces d'appui pour l'élément optique (6).

5. Système optique selon l'une des revendications 1 à 4, **caractérisé en ce que** les vérins (8a, 8b et 9a, 9b) sont conçus comme des unités de traction et de pression (8a, 8b et 9a, 9b).

6. Système optique selon la revendication 5, **caractérisé en ce que** les unités de traction et de pression (8a, 8b et 9a, 9b) sont pourvues d'un entraînement à broche (16), une force de traction et de pression pouvant être exercée, par l'intermédiaire de l'écrou de la broche (17), sur un dispositif à ressort (19, 23) qui est en prise avec le levier approprié (12).

7. Système optique selon la revendication 6, **caractérisé en ce que**, grâce au dispositif à ressort (19, 23), une conversion d'un grand trajet de réglage en un réglage fin est réglé sur le levier (12).

8. Système optique selon la revendication 7, **caractérisé en ce que** les unités de traction et de pression (8a, 8b et 9a, 9b) sont disposées dans des alésages du support (7).
